# EUROPÄISCHE PATENTSCHRIFT

(11) **EP 2 467 662 B1**
(45) Veröffentlichungstag und Bekanntmachung des Hinweises auf die Patenterteilung: **04.12.2013**
(21) Anmeldenummer: 10745632.9
(22) Anmeldetag: 23.08.2010
(51) Int. Cl.: F27D 11/02, F27D 99/00, C23C 16/48, H05B 3/48

(54) **FLÄCHENHEIZEINRICHTUNG FÜR EINE SUBSTRATBEHANDLUNGSEINRICHTUNG, UND SUBSTRATBEHANDLUNGSEINRICHTUNG**
PLANAR HEATING UNIT FOR A SUBSTRATE TREATMENT DEVICE AND SUBSTRATE TREATMENT DEVICE
DISPOSITIF DE CHAUFFAGE DE SURFACES POUR DISPOSITIF DE TRAITEMENT DE SUBSTRATS, ET DISPOSITIF DE TRAITEMENT DE SUBSTRATS CORRESPONDANT

(30) Priorität: 21.08.2009 DE 102009038341
(43) Veröffentlichungstag der Anmeldung: 27.06.2012
(73) Patentinhaber: VON ARDENNE ANLAGENTECHNIK GMBH, 01324 Dresden (DE)
(72) Erfinder: HENTSCHEL, Michael, 01189 Dresden (DE); MEYER, Thomas, 01159 Dresden (DE); VON DER WAYDBRINK, Hubertus, 01326 Dresden (DE); KENNE, Marco, 01099 Dresden (DE); STANGE, Daniel, 01109 Dresden (DE); HECHT, Hans-Christian, 01689 Weinboehla (DE)
(74) Vertreter: Lippert, Stachow & Partner
(86) Internationale Anmeldenummer: PCT/EP2010/062264
(87) Internationale Veröffentlichungsnummer: WO 2011/020924

(56) Entgegenhaltungen:
- US-A- 4 079 921

## Beschreibung

Die Erfindung betrifft eine Flächenheizeinrichtung für eine Sustratbehandlungseinrichtung gemäß Oberbegriff des Patentanspruchs 1 sowie eine Substratbehandlungseinrichtung gemäß Oberbegriff des Patentanspruchs 10.

Bei der Behandlung von Substraten, beispielsweise der Beschichtung oder Diffusionsbehandlung flächiger Substrate zur Herstellung beschichteter Glasscheiben oder von Dünnschicht-Solarzellen, müssen die Substrate aufgeheizt werden. Hierfür sind Flächenheizeinrichtungen bekannt, bei denen ein sogenannter Mantelrohrheizer verwendet wird.

Mantelrohrheizer weisen in einem Mantelrohr aus Aluminium, Edelstahl oder einem anderen metallischen Werkstoff einen Widerstandsheizdraht auf, der gegen das Mantelrohr elektrisch isoliert, beispielsweise in keramische Isolationselemente aus Aluminiumoxid oder anderen geeigneten Stoffen eingebettet ist.

Wichtig ist es, eine möglichst gleichmäßige Erwärmung des Substrats zu erzielen. Daher werden bei sogenannten Durchlaufanlagen zur Behandlung scheibenförmiger Substrate beispielsweise Flächenheizeinrichtungen verwendet, bei denen einer oder mehrere Mantelrohrheizer so geformt sind, dass sich gerade und gebogene Rohrabschnitte abwechseln, wobei die geraden Rohrabschnitte parallel zueinander in einer nachfolgend als Hauptebene bezeichneten Ebene verlaufen. Je zwei benachbarte gerade Rohrabschnitte sind am Rand der Flächenheizeinrichtung durch einen gebogenen Rohrabschnitt miteinander verbunden, welcher ebenfalls in der Hauptebene liegt. Die Flächenheizeinrichtung wird in der Substratbehandlungseinrichtung im allgemeinen so angeordnet, dass die Hauptebene parallel zur Transportebene der Substrate ausgerichtet ist, wobei die geraden Rohrabschnitte des Mantelrohrheizers meist quer zur Transportrichtung der Substrate ausgerichtet sind.

Unter einer Flächenheizeinrichtung soll nachfolgend eine Heizeinrichtung verstanden werden, bei der drei oder mehr gerade Rohrabschnitte, die elektrisch in Reihe geschaltet und durch gemeinsame Stromanschlüsse elektrisch beheizbar sind, in ein und derselben Ebene, die nachfolgend Hauptebene genannt wird, angeordnet sind und bei der je zwei benachbarte gerade Rohrabschnitte durch einen gebogenen Rohrabschnitt miteinander verbunden sind. Dadurch, dass die geraden Rohrabschnitte parallel zueinander in derselben Ebene angeordnet sind, strahlt eine derartige Flächenheizeinrichtung die von ihr erzeugte Wärmeenergie hauptsächlich senkrecht zur Hauptebene ab.

Dies ist ein entscheidender Unterschied zu Heizeinrichtungen, die die Wärmeenergie im wesentlichen punktförmig erzeugen und daher gleichmäßig nach allen Seiten abstrahlen, wie beispielsweise bei der Vorrichtung, die in JP 09236268 A beschrieben ist, oder die Wärme entlang einer kreisförmigen Linie abstrahlen wie die aus US 2,483,839 bekannte Vorrichtung.

Aus US 4,079,921 ist hingegen ein Heizelement bekannt, bei dem ein in der Hauptebene liegender gerader Rohrabschnitt mit zwei in einer Nebenebene liegenden geraden Rohrabschnitten durch gebogene Rohrabschnitte verbunden ist, allerdings weist hier jeder in der Hauptebene liegende gerade Rohrabschnitt eine eigene Stromversorgung auf, und erst durch entsprechende Anordnung vieler derartiger Heizelemente entsteht eine Flächenheizeinrichtung, bei der viele in derselben Hauptebene liegende gerade Rohrabschnitte eine Flächenheizeinrichtung bilden. Nachteilig an dieser Lösung ist beispielsweise, dass viele Stromanschlüsse benötigt werden, aber auch, dass die in der Nebenebene liegenden geraden Rohrabschnitte unvermeidlich sind, unabhängig davon ob ihre Heizleistung benötigt wird oder nicht.

Demgegenüber geht die Erfindung von einer Flächenheizeinrichtung aus, bei der drei oder mehr, meist im wesentlichen gleich lange gerade Rohrabschnitte, die durch eine gemeinsame Stromversorgung elektrisch beheizbar sind, in ein und derselben Ebene, die nachfolgend Hauptebene genannt wird, äquidistand zueinander angeordnet sind und bei der je zwei benachbarte gerade Rohrabschnitte durch einen gebogenen Rohrabschnitt miteinander verbunden sind. Mit anderen Worten sind demnach die Heizdrähte oder Abschnitte eines Heizdrahts, der sich durch die geraden Rohrabschnitte zieht, elektrisch in Reihe geschaltet und werden durch gemeinsame Stromanschlüsse gespeist, die an je einem Ende der Konfiguration aus geraden und gebogenen Rohrabschnitten angeordnet sind.

Zur Herstellung derartiger Flächenheizeinrichtungen muss der Mantelrohrheizer demnach mehrfach gebogen werden, um die gebogenen Rohrabschnitte zu erhalten, welche die geraden Rohrabschnitte miteinander verbinden. Dabei besteht eine Beschränkung darin, dass die Biegeradien der gebogenen Rohrabschnitte nicht beliebig klein gewählt werden können. Abhängig von Durchmesser, Wandstärke und Material des Mantelrohrs darf der Biegeradius nicht kleiner sein als ein vorgegebener Mindestradius. Daraus ergibt sich die Schwierigkeit, dass die geraden Rohrabschnitte nicht beliebig eng nebeneinander angeordnet werden können, weshalb der Leistungsdichte der Flächenheizeinrichtung Grenzen gesetzt sind. Weiterhin leidet die Homogenität des Wärmeeintrags in das Substrat darunter, dass die geraden Rohrabschnitte einen durch den Mindestradius bestimmten Mindestabstand aufweisen.

Hier soll die Erfindung Abhilfe schaffen, indem die Leistungsdichte erhöht und die Homogenität der Wärmeabstrahlung verbessert wird.

Diese Aufgabe wird gelöst durch eine Flächenheizeinrichtung mit den Merkmalen des Patentanspruchs 1 sowie durch eine Substratbehandlungseinrichtung mit den Merkmalen des Patentanspruchs 10. Vorteilhafte Ausgestaltungen und Weiterbildungen sind in den abhängigen Patentansprüchen beschrieben.

Vorgeschlagen wird bei einer Flächenheizeinrichtung für eine Substratbehandlungseinrichtung zur hauptsächlich flächenhaften Abstrahlung von Wärme senkrecht zu einer Hauptebene, die einen Mantelrohrheizer mit mindestens drei in einer gemeinsamen Ebene parallel zueinander angeordneten, elektrisch mittels Widerstandsheizdraht über zwei gemeinsame, an den beiden Enden des Mantelrohrs angeordneten Stromanschlüsse beheizbaren, geraden Rohrabschnitten und gebogenen Rohrabschnitten umfasst, wobei mindestens zwei gerade Rohrabschnitte parallel zueinander in einer Hauptebene angeordnet und an ihren Enden mit mindestens einem anderen geraden Rohrabschnitt jeweils durch gebogene Rohrabschnitte miteinander verbunden sind, dass zumindest ein Teil der gebogenen Rohrabschnitte relativ zur Hauptebene geneigt ausgerichtet ist.

Durch diese Maßnahme wird es möglich, gerade Rohrabschnitte des Mantelrohrheizers in der Hauptebene mit einem geringeren Abstand zueinander anzuordnen, als dies bei herkömmlichen Mantelrohrheizern aufgrund des Mindestbiegeradius' möglich wäre. Hierfür sind verschiedene Ausgestaltungen möglich, von denen nachfolgend drei Varianten näher beschrieben werden.

Die erste Variante führt zu einem Mantelrohrheizer, bei dem wie bei bekannten Flächenheizeinrichtungen alle geraden Rohrabschnitte in der Hauptebene angeordnet sind, aber mit einem geringeren Abstand als bei den bekannten Flächenheizeinrichtungen. Die zweite Variante hingegen führt zu einem Mantelrohrheizer, bei dem ein Teil der geraden Rohrabschnitte in der Hauptebene und ein anderer Teil der geraden Rohrabschnitte in einer Nebenebene angeordnet sind. Bereits dadurch können die geraden Rohrabschnitte in einem geringeren Abstand als bei den bekannten Flächenheizeinrichtungen angeordnet werden, wenn je ein in der Nebenebene angeordneter gerader Rohrabschnitt zwischen zwei in der Hauptebene nebeneinander angeordneten geraden Rohrabschnitten liegt.

Die erste Variante wird dadurch realisiert, dass ein erster gebogener Rohrabschnitt drei Halbbögen umfasst, wobei ein erster Halbbogen von einem ersten Ende eines ersten geraden Rohrabschnitts ausgehend aus der Hauptebene heraus in eine parallele Nebenebene führt und dort in einen zweiten Halbbogen, der in der Nebenebene liegt, übergeht, und der zweite Halbbogen in einen dritten Halbbogen übergeht, der aus der Nebenebene heraus in die Hauptebene zurückführt und dort in ein erstes Ende eines zweiten geraden Rohrabschnitts übergeht.

Unter einem Halbbogen soll dabei ein Bogen verstanden werden, dessen Endquerschnitte parallel zueinander verlaufen. Ein Beispiel für einen Halbbogen in diesem Sinne ist ein Halbkreisbogen, jedoch sind von dem Begriff auch andere Bogenformen umfasst, die eine unregelmäßige Form aufweisen.

Der erste und der dritte Halbbogen können dabei senkrecht oder unter einem anderen Winkel zur Hauptebene ausgerichtet sein. Dieser Neigungswinkel ist mitbestimmend dafür, welcher Abstand zwischen zwei benachbarten geraden Rohrabschnitten des Mantelrohrheizers erzielt wird. Mit anderen Worten lässt sich der Abstand zweier benachbarter gerader Rohrabschnitte dadurch einstellen, dass der Neigungswinkel des ersten und dritten Halbbogens variiert wird. So wie dabei sehr geringe Abstände benachbarter gerader Rohrabschnitte realisiert werden können, ist es jedoch auch möglich, größere Abstände einzustellen, wenn die ersten und dritten Halbbögen der gebogenen Rohrabschnitte gegensinnig geneigt sind.

In einer Weiterbildung der ersten Variante ist vorgesehen, dass ein zweiter gebogener Rohrabschnitt drei Halbbögen umfasst, wobei ein erster Halbbogen von dem zweiten Ende des zweiten geraden Rohrabschnitts ausgehend aus der Hauptebene heraus in die Nebenebene führt und dort in einen zweiten Halbbogen, der in der Nebenebene liegt, übergeht, und der zweite Halbbogen in einen dritten Halbbogen übergeht, der aus der Nebenebene heraus in die Hauptebene zurückführt und dort in ein zweites Ende eines dritten geraden Rohrabschnitts übergeht.

Durch die abwechselnde Anordnung der beschriebenen gebogenen Rohrabschnitte, die je drei Halbbögen umfassen, ist es möglich, beliebig viele gerade Rohrabschnitte parallel zueinander in der Hauptebene anzuordnen.

Die zweite Variante wird dadurch realisiert, dass ein erster gebogener Rohrabschnitt einen Halbbogen umfasst, der von einem ersten Ende eines ersten geraden Rohrabschnitts ausgehend aus der Hauptebene heraus in eine parallele Nebenebene führt und dort in das erste Ende eines zweiten geraden Rohrabschnitts, der in der Nebenebene liegt, übergeht.

Im Gegensatz zur ersten Variante sind hier die geraden Rohrabschnitte abwechselnd in der Hauptebene und einer dazu parallelen Nebenebene angeordnet. Bei dieser Variante ist die Herstellung wesentlich einfacher, weil zwischen zwei benachbarten geraden Rohrabschnitten jeweils nur ein Biegeschritt durchzuführen ist. Die Homogenität der Wärmeabstrahlung ist dennoch höher als bei bekannten Flächenheizeinrichtungen, weil zwischen je zwei benachbarten geraden Rohrabschnitten der Hauptebene je ein gerader Rohrabschnitt der Nebenebene angeordnet ist. Außerdem lassen sich auf diese Weise die geraden Rohrabschnitte sowohl der Hauptebene als auch der Nebenebene beliebig dicht nebeneinander anordnen, im Grenzfall sogar so, dass sich in derselben Ebene benachbarte gerade Rohrabschnitte berühren.

Darüber hinaus ist die zweite Variante besonders gut geeignet, wenn eine beidseitige Wärmeabstrahlung gewünscht wird, weil die Hauptebene und die Nebenebene gleichwertig sind. Gegebenenfalls können zwischen Haupt- und Nebenebene ein Wärmedämmelement zur thermischen Trennung oder/und ein oder mehrere Reflektoren zur gerichteten Wärmeabstrahlung angeordnet werden.

In einer Weiterbildung der ersten Variante ist vorgesehen, dass ein zweiter gebogener Rohrabschnitt einen Halbbogen umfasst, der von dem zweiten Ende des zweiten geraden Rohrabschnitts ausgehend aus der Nebenebene heraus in die Hauptebene führt und dort in das zweite Ende eines dritten geraden Rohrabschnitts, der in der Hauptebene liegt, übergeht.

Durch die abwechselnde Anordnung der beschriebenen gebogenen Rohrabschnitte, die je einen Halbbogen umfassen, ist es möglich, beliebig viele gerade Rohrabschnitte parallel zueinander in der Hauptebene und der Nebenebene anzuordnen.

Die dritte Variante wird dadurch realisiert, dass ein erster gebogener Rohrabschnitt einen Halbbogen und zwei Viertelbögen umfasst, wobei der Halbbogen von einem ersten Ende eines ersten geraden Rohrabschnitts ausgehend aus der Hauptebene heraus in eine parallele Nebenebene führt und dort in einen ersten Viertelbogen übergeht und der erste Viertelbogen in einen zweiten Viertelbogen übergeht, wobei der erste Viertelbogen und der zweite Viertelbogen gemeinsam aus der Nebenebene heraus in die Hauptebene zurückführen und der zweite Viertelbogen dort in ein erstes Ende eines zweiten geraden Rohrabschnitts übergeht.

Unter einem Viertelbogen soll dabei ein Bogen verstanden werden, dessen Endquerschnitte rechtwinklig zueinander verlaufen. Ein Beispiel für einen Viertelbogen in diesem Sinne ist ein Viertelkreisbogen, jedoch sind von dem Begriff auch andere Bogenformen umfasst, die eine unregelmäßige Form aufweisen.

Wie bei der ersten Variante sind hier die geraden Rohrabschnitte ausschließlich in der Hauptebene angeordnet. Die Gestaltung der gebogenen Rohrabschnitte aus je einem Halbbogen und zwei Viertelbögen ist mit geringem Materialeinsatz realisierbar.

In einer Weiterbildung der dritten Variante ist vorgesehen, dass ein zweiter gebogener Rohrabschnitt zwei Viertelbögen und einen Halbbogen umfasst, wobei ein erster Viertelbogen von dem zweiten Ende des zweiten geraden Rohrabschnitts ausgehend aus der Hauptebene heraus führt und in einen ersten Viertelbogen übergeht, der in die Nebenebene führt und dort in den Halbbogen übergeht, und der Halbbogen aus der Nebenebene heraus in die Hauptebene zurückführt und dort in ein zweites Ende eines dritten geraden Rohrabschnitts übergeht.

In einer weiteren Ausgestaltung kann vorgesehen sein, dass mindestens ein Mantelrohrheizer an mindestens einer Stützstruktur angeordnet ist, welche auf einer Trägerstruktur angeordnet ist.

Dabei kann die Trägerstruktur beispielsweise plattenförmig oder/und als Wärmedämmelement oder/und als Reflektor ausgebildet sein. Weiter kann die Trägerstruktur so angeordnet sein, dass sich der gesamte Mantelrohrheizer auf einer Seite der Trägerstruktur befindet, oder dass sich auf jeder Seite der Trägerstruktur ein Teil der Rohrabschnitte des Mantelrohrheizers befindet.

Die Stützstruktur kann beispielsweise ein Blechformteil sein, welches Aussparungen zur Aufnahme gerader Rohrabschnitte des Mantelrohrheizers aufweist. Diese Ausgestaltung ermöglicht die sichere Befestigung des Mantelrohrheizers bei geringem Gewicht der Stützstruktur und gleichzeitig den Ausgleich von Wärmedehnungen des Mantelrohrheizers.

In einer weiteren Ausgestaltung kann vorgesehen sein, dass die Stromanschlüsse des Mantelrohrheizers auf der dem Mantelrohrheizer gegenüberliegenden Seite der Trägerstruktur angeordnet sind.

Die beschriebene Flächenheizeinrichtung kann vorteilhaft in einer Substratbehandlungseinrichtung verwendet werden, die eine Kammer und mindestens eine Substratbehandlungseinrichtung sowie eine Transporteinrichtung zum Transport von Substraten durch die Kammer umfasst, wobei in der Kammer mindestens eine der beschriebenen Flächenheizeinrichtungen angeordnet ist.

Eine Substratbehandlungseinrichtung in diesem Sinne kann beispielsweise eine Beschichtungs- oder Abtragseinrichtung oder eine Diffusionszone sein.

Die Transporteinrichtung kann beispielsweise eine Anordnung paralleler Transportwalzen oder Transportrollen für plattenförmige Substrate oder Substrathalter umfassen, welche eine Transportebene für die Substrate definieren, und die Flächenheizeinrichtung so angeordnet sein, dass die Hauptebene parallel zur Transportebene ausgerichtet ist.

Für Anlagen zur horizontalen Substratbehandlung definieren die obersten Mantellinien horizontal angeordneter Transportwalzen, auf die die Substrate mit oder ohne Substrathalter aufgelegt werden, eine horizontale Transportebene. Für Anlagen zur vertikalen Substratbehandlung definieren die Transportrollen, auf die die Substrate mit oder ohne Substrathalter senkrecht oder unter einem geringen Neigungswinkel gestellt werden, meist im Zusammenwirken mit Stützrollen, um ein Kippen der Substrate zu verhindern, eine vertikale oder gegenüber der Vertikalen um den Neigungswinkel geneigte Transportebene.

In einer Ausgestaltung der Substratbehandlungseinrichtung ist vorgesehen, dass gerade Rohrabschnitte des Mantelrohrheizers senkrecht zur Transportrichtung der Substrate angeordnet sind. Hierdurch wird ein besonders homogener Wärmeeintrag in die Substrate realisiert.

Nachfolgend wird die vorgeschlagene Flächenheizeinrichtung anhand zweier Ausführungsbeispiele und zugehöriger Zeichnungen näher erläutert.

Dabei zeigen
Fig. 1 das erste Ausführungsbeispiel in Seitenansicht und Draufsicht,
Fig. 2 das erste Ausführungsbeispiel in perspektivischer Ansicht,
Fig. 3 das zweite Ausführungsbeispiel in Seitenansicht und Draufsicht,
Fig. 4 das erste Ausführungsbeispiel in perspektivischer Ansicht,
Fig. 5 das dritte Ausführungsbeispiel in Seitenansicht und Draufsicht, und
Fig. 6 das dritte Ausführungsbeispiel in perspektivischer Ansicht.

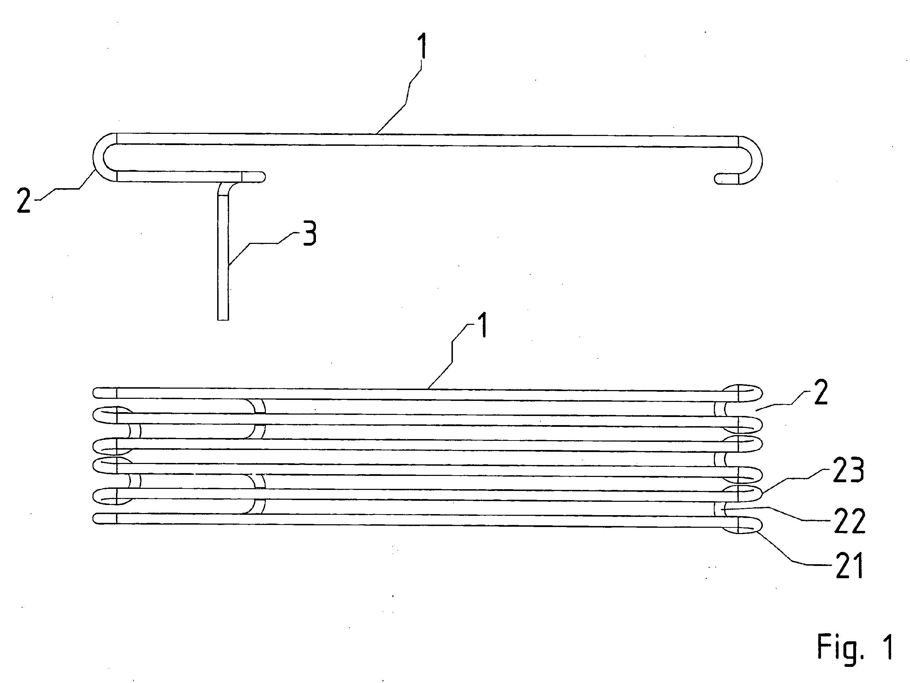

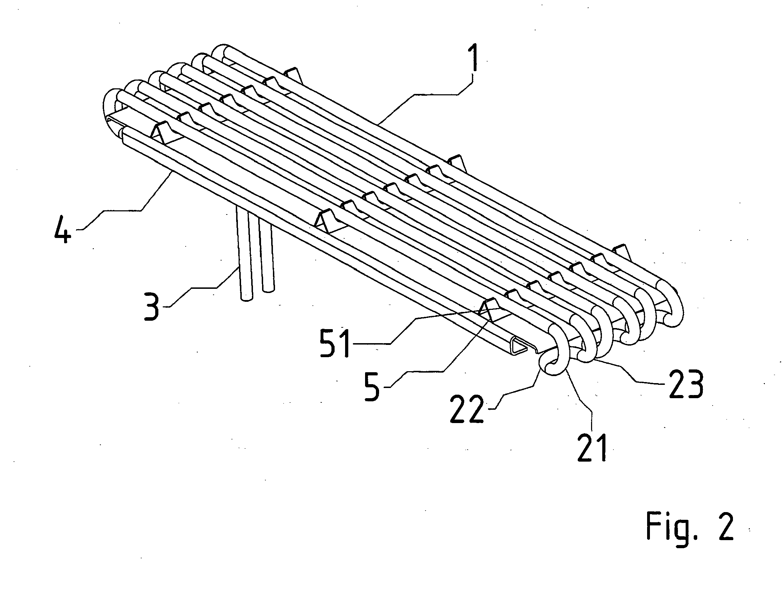

Bei dem Ausführungsbeispiel der Figuren 1 und 2 befinden sich alle geraden Rohrabschnitte 1 des Mantelrohrheizers in der Hauptebene, wo sie mit einem definierten Abstand zueinander angeordnet sind. Dieser Abstand ist geringer als der doppelte Mindestradius, der beim Biegen des Mantelrohrheizers einzuhalten ist.

Dies wird dadurch erreicht, dass die an den Enden der geraden Rohrabschnitte 1 angeordneten gebogenen Rohrabschnitte 2 jeweils einen ersten Halbbogen 21, einen zweiten Halbbogen 22 und einen dritten Halbbogen 23 umfassen. Der erste Halbbogen 21 und der zweite Halbbogen 23 sind gegenüber der Hauptebene geneigt und mit je einem geraden Rohrabschnitt 1 des Mantelrohrheizers verbunden. Der zweite Halbbogen 22 liegt in einer zur Hauptebene parallelen Nebenebene und verbindet den ersten Halbbogen 21 mit dem dritten Halbbogen 23. Obwohl die Enden aller drei Halbbögen 21, 22, 23 jeweils einen Abstand zueinander aufweisen, der dem doppelten Mindestradius entspricht, sind die geraden Rohrabschnitte 1 mit einem Abstand zueinander angeordnet, der geringer ist als der doppelte Mindestradius. Dies wird dadurch erreicht, dass der erste Halbbogen und der dritte Halbbogen nicht senkrecht zur Hauptebene ausgerichtet sind.

Es ist weiterhin eine im Wesentlichen plattenförmige Trägerstruktur 4 vorgesehen, auf der zwei als Blechformteil ausgeführte Stützstrukturen 5 mit Aussparungen 51 angeordnet sind. Die Stromanschlüsse 3 des Mantelrohrheizers sind auf der dem Mantelrohrheizer gegenüberliegenden Seite der Trägerstruktur 4 angeordnet.

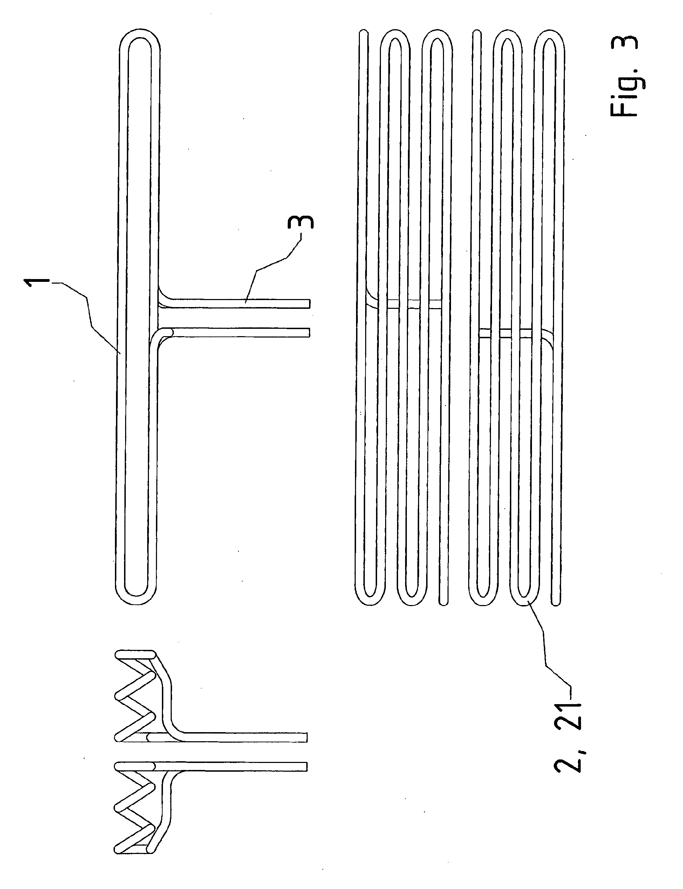

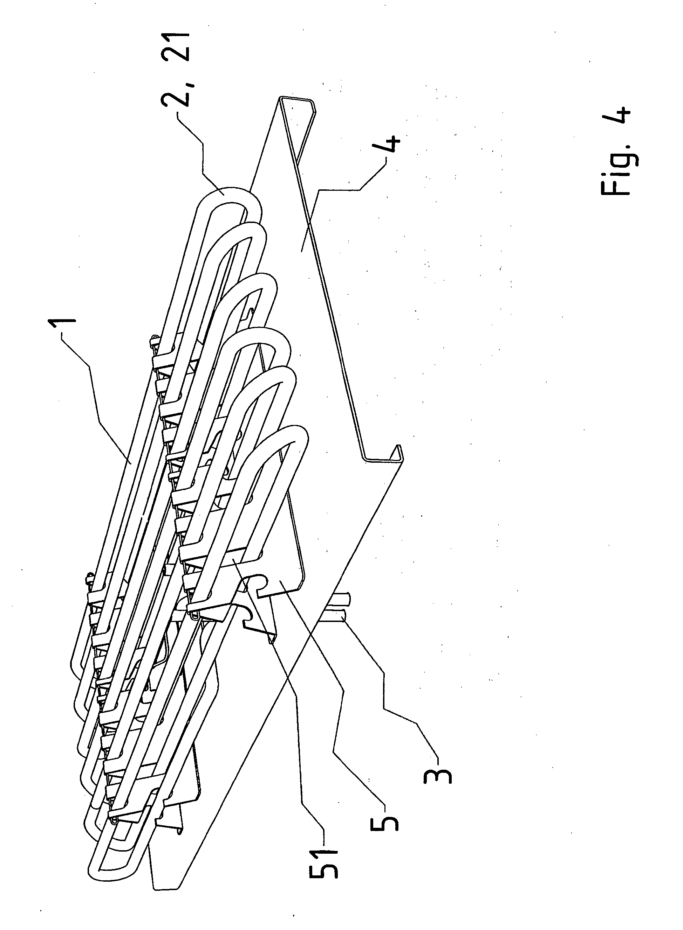

Bei dem Ausführungsbeispiel der Figuren 3 und 4 befinden sich einige gerade Rohrabschnitte 1 des Mantelrohrheizers in der Hauptebene und einige gerade Rohrabschnitte 1 des Mantelrohrheizers in der Nebenebene, wo sie jeweils mit einem definierten Abstand zueinander angeordnet sind, wobei zwischen je zwei in der Hauptebene angeordneten geraden Rohrabschnitten 1 je ein gerader Rohrabschnitt 1 in der Nebenebene angeordnet ist. Dieser Abstand ist geringer als der doppelte Mindestradius, der beim Biegen des Mantelrohrheizers einzuhalten ist.

Dies wird dadurch erreicht, dass die je zwei Enden der geraden Rohrabschnitte 1 von Hauptebene und Nebenebene verbindenden gebogenen Rohrabschnitte 2 jeweils einen ersten Halbbogen 21 umfassen, der gegenüber der Hauptebene geneigt ist. Obwohl die Enden der Halbbögen 21 jeweils einen Abstand zueinander aufweisen, der dem doppelten Mindestradius entspricht, sind die geraden Rohrabschnitte 1 der Hauptebene zu den geraden Rohrabschnitten 1 der Nebenebene mit einem Abstand angeordnet, der geringer ist als der doppelte Mindestradius.

Es ist weiterhin eine im Wesentlichen plattenförmige Trägerstruktur 4 vorgesehen, auf der zwei als Blechformteil ausgeführte Stützstrukturen 5 mit Aussparungen 51 angeordnet sind. Die Stromanschlüsse 3 des Mantelrohrheizers sind auf der dem Mantelrohrheizer gegenüberliegenden Seite der Trägerstruktur 4 angeordnet.

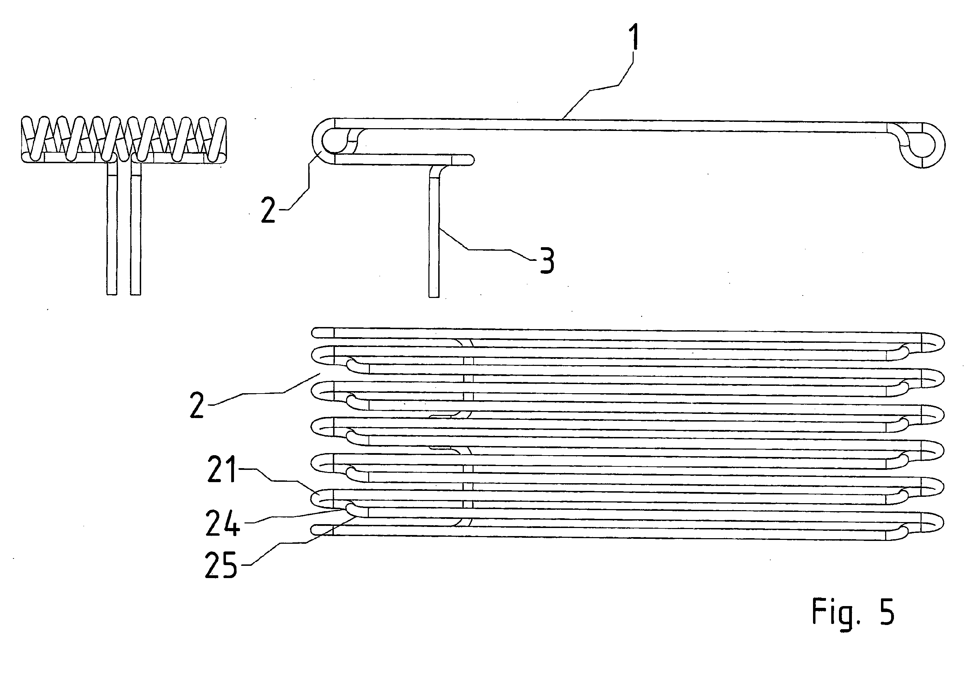

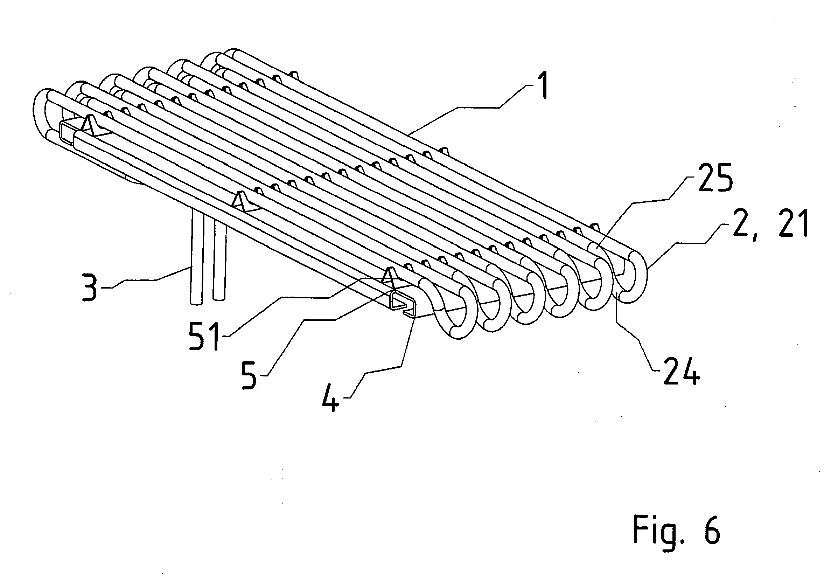

Bei dem Ausführungsbeispiel der Figuren 5 und 6 befinden sich alle geraden Rohrabschnitte 1 des Mantelrohrheizers in der Hauptebene, wo sie mit einem definierten Abstand zueinander angeordnet sind. Dieser Abstand ist geringer als der doppelte Mindestradius, der beim Biegen des Mantelrohrheizers einzuhalten ist.

Dies wird dadurch erreicht, dass die an den Enden der geraden Rohrabschnitte 1 angeordneten gebogenen Rohrabschnitte 2 jeweils einen ersten Halbbogen 21, einen ersten Viertelbogen 24 und einen zweiten Viertelbogen 25 umfassen.

Die Verbindung zwischen den Enden zweier benachbarter gerader Rohrabschnitte 1 erfolgt stets durch eine Kombination dieser drei Elemente, wobei der Halbbogen 21 vom Ende des ersten geraden Rohrabschnitts aus in die Nebenebene führt und die beiden Viertelbögen 24, 25 gemeinsam vom Ende des zweiten geraden Rohrabschnitts 1 aus in die Nebenebene führen, wo der Halbbogen in einen Viertelbogen 24 übergeht.

Es ist weiterhin eine im Wesentlichen plattenförmige Trägerstruktur 4 vorgesehen, auf der zwei als Blechformteil ausgeführte Stützstrukturen 5 mit Aussparungen 51 angeordnet sind. Die Stromanschlüsse 3 des Mantelrohrheizers sind auf der dem Mantelrohrheizer gegenüberliegenden Seite der Trägerstruktur 4 angeordnet.

### Bezugszeichenliste

- 1: gerader Rohrabschnitt
- 2: gebogener Rohrabschnitt
- 21: erster Halbbogen
- 22: zweiter Halbbogen
- 23: dritter Halbbogen
- 24: erster Viertelbogen
- 25: zweiter Viertelbogen
- 3: Stromanschluss
- 4: Trägerstruktur
- 5: Stützstruktur
- 51: Aussparung

## Patentansprüche

1. Flächenheizeinrichtung für eine Substratbehandlungseinrichtung zur hauptsächlich flächenhaften Abstrahlung von Wärme senkrecht zu einer Hauptebene, umfassend einen Mantelrohrheizer mit mindestens drei in einer gemeinsamen Ebene parallel und äquidistant zueinander angeordneten, elektrisch mittels Widerstandsheizdraht über zwei gemeinsame, an den beiden Enden des Mantelrohrs angeordneten Stromanschlüsse beheizbaren, geraden Rohrabschnitten (1) und gebogenen Rohrabschnitten (2), wobei mindestens zwei gerade Rohrabschnitte (1) parallel zueinander in einer Hauptebene angeordnet und an ihren Enden mit mindestens einem benachbarten geraden Rohrabschnitt (1), der in der Hauptebene oder einer parallelen Nebenebene angeordnet ist, jeweils durch gebogene Rohrabschnitte (2) miteinander verbunden sind, **dadurch gekennzeichnet, dass** zumindest ein Teil der gebogenen Rohrabschnitte (2) aus der Hauptebene heraus geneigt ausgerichtet ist.

2. Flächenheizeinrichtung nach Anspruch 1, **dadurch gekennzeichnet, dass** ein erster gebogener Rohrabschnitt (2) drei Halbbögen (21, 22, 23) umfasst, wobei ein erster Halbbogen (21) von einem ersten Ende eines ersten geraden Rohrabschnitts (1) ausgehend aus der Hauptebene heraus in eine parallele Nebenebene führt und dort in einen zweiten Halbbogen (22), der in der Nebenebene liegt, übergeht, und der zweite Halbbogen (22) in einen dritten Halbbogen (23) übergeht, der aus der Nebenebene heraus in die Hauptebene zurückführt und dort in ein erstes Ende eines zweiten geraden Rohrabschnitts (1) übergeht.

3. Flächenheizeinrichtung nach Anspruch 2, **dadurch gekennzeichnet, dass** ein zweiter gebogener Rohrabschnitt (2) drei Halbbögen (21, 22, 23) umfasst, wobei ein erster Halbbogen (21) von dem zweiten Ende des zweiten geraden Rohrabschnitts (1) ausgehend aus der Hauptebene heraus in die Nebenebene führt und dort in einen zweiten Halbbogen (22), der in der Nebenebene liegt, übergeht, und der zweite Halbbogen (22) in einen dritten Halbbogen (23) übergeht, der aus der Nebenebene heraus in die Hauptebene zurückführt und dort in ein zweites Ende eines dritten geraden Rohrabschnitts (1) übergeht.

4. Flächenheizeinrichtung nach Anspruch 1, **dadurch gekennzeichnet, dass** ein erster gebogener Rohrabschnitt (2) einen Halbbogen (21) umfasst, der von einem ersten Ende eines ersten geraden Rohrabschnitts (1) ausgehend aus der Hauptebene heraus in eine parallele Nebenebene führt und dort in das erste Ende eines zweiten geraden Rohrabschnitts (1), der in der Nebenebene liegt, übergeht.

5. Flächenheizeinrichtung nach Anspruch 4, **dadurch gekennzeichnet, dass** ein zweiter gebogener Rohrabschnitt (2) einen Halbbogen (21) umfasst, der von dem zweiten Ende des zweiten geraden Rohrabschnitts (1) ausgehend aus der Nebenebene heraus in die Hauptebene führt und dort in das zweite Ende eines dritten geraden Rohrabschnitts (1), der in der Hauptebene liegt, übergeht.

6. Flächenheizeinrichtung nach Anspruch 1, **dadurch gekennzeichnet, dass** ein erster gebogener Rohrabschnitt (2) einen Halbbogen (21) und zwei Viertelbögen (24, 25) umfasst, wobei der Halbbogen (21) von einem ersten Ende eines ersten geraden Rohrabschnitts (1) ausgehend aus der Hauptebene heraus in eine parallele Nebenebene führt und dort in einen ersten Viertelbogen (24) übergeht und der erste Viertelbogen (24) in einen zweiten Viertelbogen (25) übergeht, wobei der erste Viertelbogen (24) und der zweite Viertelbogen (25) gemeinsam aus der Nebenebene heraus in die Hauptebene zurückführen und der zweite Viertelbogen (25) dort in ein erstes Ende eines zweiten geraden Rohrabschnitts (1) übergeht.

7. Flächenheizeinrichtung nach Anspruch 6, **dadurch gekennzeichnet, dass** ein zweiter gebogener Rohrabschnitt (2) zwei Viertelbögen (24, 25) und einen Halbbogen (21) umfasst, wobei ein zweiter Viertelbogen (25) von dem zweiten Ende des zweiten geraden Rohrabschnitts (1) ausgehend aus der Hauptebene heraus führt und in einen ersten Viertelbogen (24) übergeht, der in die Nebenebene führt und dort in den Halbbogen (21) übergeht, und der Halbbogen (21) aus der Nebenebene heraus in die Hauptebene zurückführt und dort in ein zweites Ende eines dritten geraden Rohrabschnitts (1) übergeht.

8. Flächenheizeinrichtung nach einem der vorherigen Ansprüche, **dadurch gekennzeichnet, dass** mindestens ein Mantelrohrheizer an mindestens einer Stützstruktur (5) angeordnet ist, welche auf einer Trägerstruktur (4) angeordnet ist.

9. Flächenheizeinrichtung nach Anspruch 8, **dadurch gekennzeichnet, dass** die Trägerstruktur (4) plattenförmig ist.

10. Flächenheizeinrichtung nach Anspruch 8 oder 9, **dadurch gekennzeichnet, dass** die Stützstruktur (5) ein Blechformteil ist, welches Aussparungen (51) zur Aufnahme gerader Rohrabschnitte (1) des Mantelrohrheizers aufweist.

11. Flächenheizeinrichtung nach einem der Ansprüche 8 bis 10, **dadurch gekennzeichnet, dass** die Stromanschlüsse (3) des Mantelrohrheizers auf der dem Mantelrohrheizer gegenüberliegenden Seite der Trägerstruktur (4) angeordnet sind.

12. Substratbehandlungseinrichtung, umfassend eine Kammer und mindestens eine Substratbehandlungseinrichtung sowie eine Transporteinrichtung zum Transport von Substraten durch die Kammer, **dadurch gekennzeichnet, dass** in der Kammer mindestens eine Flächenheizeinrichtung nach einem der Ansprüche 1 bis 9 angeordnet ist.

13. Substratbehandlungseinrichtung nach Anspruch 10, **dadurch gekennzeichnet, dass** die Transporteinrichtung eine Anordnung paralleler Transportwalzen oder Transportrollen für plattenförmige Substrate oder Substrathalter umfasst, welche eine Transportebene für die Substrate definieren, und die Flächenheizeinrichtung so angeordnet ist, dass die Hauptebene parallel zur Transportebene ausgerichtet ist.

14. Substratbehandlungseinrichtung nach Anspruch 10, **dadurch gekennzeichnet, dass** gerade Rohrabschnitte (1) des Mantelrohrheizers senkrecht zur Transportrichtung der Substrate angeordnet sind.

## Claims

1. Planar heating unit for a substrate treatment device for the mainly planar radiation of heat perpendicularly to a main plane, comprising a jacket tube heater with at least three straight tube sections (1) and bent tube sections (2) which are arranged in a common plane parallel to and equidistantly from one another and are heatable electrically by means of resistance heating wire via two common current terminals arranged at the two ends of the jacket tube, at least two straight tube sections (1) being arranged parallel to one another in a main plane and being connected to one another at their ends in each case by bent tube sections (2) by means of at least one adjacent straight tube section (1) which is arranged in the main plane or in a parallel secondary plane, **characterized in that** at least some of the bent tube sections (2) are oriented so as to be inclined out of the main plane.

2. Planar heating unit according to Claim 1, **characterized in that** a first bent tube section (2) comprises three semi-arcs (21, 22, 23), a first semi-arc (21) leading from a first end of a first straight tube section (1) out of the main plane into a parallel secondary plane and merging there into a second semi-arc (22) which lies in the secondary plane, and the second semi-arc (22) merging into a third semi-arc (23) which leads out of the secondary plane back into the main plane and merges there into a first end of a second straight tube section (1).

3. Planar heating unit according to Claim 2, **characterized in that** a second bent tube section (2) comprises three semi-arcs (21, 22, 23), a first semi-arc (21) leading from the second end of the second straight tube section (1) out of the main plane into the secondary plane and merging there into a second semi-arc (22) which lies in the secondary plane, and the second semi-arc (22) merging into a third semi-arc (23) which leads out of the secondary plane back into the main plane and merges there into a second end of a third straight tube section (1).

4. Planar heating unit according to Claim 1, **characterized in that** a first bent tube section (2) comprises a semi-arc (21) which leads from a first end of a first straight tube section (1) out of the main plane into a parallel secondary plane and merges there into the first end of a second straight tube section (1) which lies in the secondary plane.

5. Planar heating unit according to Claim 4, **characterized in that** a second bent tube section (2) comprises a semi-arc (21) which leads from the second end of the second straight tube section (1) out of the secondary plane into the main plane and merges there into the second end of a third straight tube section (1) which lies in the main plane.

6. Planar heating unit according to Claim 1, **characterized in that** a first bent tube section (2) comprises a semi-arc (21) and two quarter-arcs (24, 25), the semi-arc (21) leading from a first end of a first straight tube section (1) out of the main plane into a parallel secondary plane and merging there into a first quarter-arc (24), and the first quarter-arc (24) merging into a second quarter-arc (25), the first quarter-arc (24) and the second quarter-arc (25) leading together out of the secondary plane back into the main plane, and the second quarter-arc (25) merging there into a first end of a second straight tube section (1).

7. Planar heating unit according to Claim 6, **characterized in that** a second bent tube section (2) comprises two quarter-arcs (24, 25) and a semi-arc (21), a second quarter-arc (25) leading from the second end of the second straight tube section (1) out of the main plane and merging into a first quarter-arc (24) which leads into the secondary plane and merges there into the semi-arc (21), and the semi-arc (21) leading out of the secondary plane back into the main plane and merging there into a second end of a third straight tube section (1).

8. Planar heating unit according to one of the preceding claims, **characterized in that** at least one jacket tube heater is arranged on at least one supporting structure (5) which is arranged on a carrier structure (4).

9. Planar heating unit according to Claim 8, **characterized in that** the carrier structure (4) is plate-shaped.

10. Planar heating unit according to Claim 8 or 9, **characterized in that** the supporting structure (5) is a sheet-metal moulding which has clearances (51) for the reception of straight tube sections (1) of the jacket tube heater.

11. Planar heating unit according to one of Claims 8 to 10, **characterized in that** the current terminals (3) of the jacket tube heater are arranged on that side of the carrier structure (4) which lies opposite the jacket tube heater.

12. Substrate treatment device, comprising a chamber and at least one substrate treatment device and also a transport device for the transport of substrates through the chamber, **characterized in that** at least one planar heating unit according to one of Claims 1 to 9 is arranged in the chamber.

13. Substrate treatment device according to Claim 12, **characterized in that** the transport device comprises an arrangement of parallel transport cylinders or transport rollers for plate-shaped substrates or substrate holders which define a transport plane for the substrates, and the planar heating unit is arranged such that the main plane is oriented parallel to the transport plane.

14. Substrate treatment device according to Claim 12, **characterized in that** straight tube sections (1) of the jacket tube heater are arranged perpendicularly to the transport direction of the substrate.

## Revendications

1. Dispositif de chauffage de surface pour installation de traitement de substrats, rayonnant principalement en surface de la chaleur perpendiculairement à un plan principal et comprenant
un dispositif de chauffage à tube d'enveloppe doté d'au moins trois tronçons tubulaires rectilignes (1) disposés dans un plan commun, parallèlement les uns aux autres et équidistants les uns par rapport aux autres, aptes à être chauffés électriquement au moyen d'un fil de résistance électrique par l'intermédiaire de deux bornes communes de raccordement de courant disposées aux deux extrémités du tube d'enveloppe, et de tronçons tubulaires cintrés (2),
au moins deux tronçons tubulaires rectilignes (1) étant disposés parallèlement l'un à l'autre dans un plan principal et raccordés à leurs extrémités par des tronçons tubulaires cintrés (2) à au moins un tronçon tubulaire rectiligne (1) voisin disposé dans le plan principal ou dans un plan secondaire parallèle, **caractérisé en ce que**
au moins une partie des tronçons tubulaires cintrés (2) est inclinée hors du plan principal.

2. Dispositif de chauffage de surface selon la revendication 1, **caractérisé en ce qu'**un premier tronçon tubulaire cintré (2) comporte deux demi-arcs (21, 22, 23), un premier demi-arc (21) conduisant hors du plan principal depuis une première extrémité d'un premier tronçon tubulaire rectiligne (1) jusque dans un plan secondaire parallèle où il se prolonge en un deuxième demi-arc (22) situé dans le plan secondaire, le deuxième demi-arc (22) se prolongeant en un troisième demi-arc (23) qui, partant du plan secondaire, revient dans le plan principal où il se prolonge en une première extrémité d'un deuxième tronçon tubulaire rectiligne (1).

3. Dispositif de chauffage de surface selon la revendication 2, **caractérisé en ce qu'**un deuxième tronçon tubulaire cintré (2) comporte trois demi-arcs (21, 22, 23), un premier demi-arc (21) partant de la deuxième extrémité du deuxième tronçon tubulaire rectiligne (1) pour sortir du plan principal et aboutir dans le plan secondaire où il se prolonge en un deuxième demi-arc (22) situé dans le plan secondaire, le deuxième demi-arc (22) se prolongeant en un troisième demi-arc (23) qui part du plan secondaire pour revenir dans le plan principal où il se prolonge en la deuxième extrémité d'un troisième tronçon tubulaire rectiligne (1).

4. Dispositif de chauffage de surface selon la revendication 1, **caractérisé en ce qu'**un premier tronçon tubulaire cintré (2) comporte un demi-arc (21) qui part d'une première extrémité d'un premier tronçon tubulaire rectiligne (1) pour sortir du plan principal et conduire dans un plan secondaire parallèle où il se prolonge en la première extrémité d'un deuxième tronçon tubulaire rectiligne (1) situé dans le plan secondaire.

5. Dispositif de chauffage de surface selon la revendication 4, **caractérisé en ce qu'**un deuxième tronçon tubulaire cintré (2) comporte un demi-arc (21) qui part de la deuxième extrémité du deuxième tronçon tubulaire rectiligne (1) pour sortir du plan secondaire et conduire dans le plan principal où il se prolonge en la deuxième extrémité d'un troisième tronçon tubulaire rectiligne (1) situé dans le plan principal.

6. Dispositif de chauffage de surface selon la revendication 1, **caractérisé en ce qu'**un premier tronçon tubulaire cintrée (2) comporte un demi-arc (21) et deux quarts d'arc (24, 25), le demi-arc (21) partant d'une première extrémité d'un premier tronçon tubulaire rectiligne (1) pour sortir hors du plan principal et aboutir dans un plan secondaire parallèle où il se prolonge en un premier quart d'arc (24), le premier quart d'arc (24) se prolongeant en un deuxième quart d'arc (25), le premier quart d'arc (24) et le deuxième quart d'arc (25) partant ensemble du plan secondaire pour revenir dans le plan principal où le deuxième quart d'arc (25) se prolonge en une première extrémité d'un deuxième tronçon tubulaire rectiligne (1).

7. Dispositif de chauffage de surface selon la revendication 6, **caractérisé en ce qu'**un deuxième tronçon tubulaire cintré (2) comporte quatre quarts d'arc (24, 25) et un demi-arc (21), un deuxième quart d'arc (25) partant de la deuxième extrémité du deuxième tronçon tubulaire rectiligne (1) pour sortir du plan principal et se prolonger en le quatrième quart d'arc (24) qui conduit dans le plan secondaire où il se prolonge en le demi-arc (21), le demi-arc (21) sortant du plan secondaire pour retourner dans le plan principal où il se prolonge en une deuxième extrémité d'un troisième tronçon tubulaire rectiligne (1).

8. Dispositif de chauffage de surface selon l'une des revendications précédentes, **caractérisé en ce qu'**au moins un dispositif de chauffage à tube d'enveloppe est disposé sur au moins une structure de soutien (5) disposée sur une structure porteuse (4).

9. Dispositif de chauffage de surface selon la revendication 8, **caractérisé en ce que** la structure porteuse (4) a la forme d'une plaque.

10. Dispositif de chauffage de surface selon les revendications 8 ou 9, **caractérisé en ce que** la structure de soutien (5) est une pièce en tôle façonnée qui présente des découpes (51) qui reprennent les tronçons tubulaires rectilignes (1) du dispositif de chauffage à tube d'enveloppe.

11. Dispositif de chauffage de surface selon l'une des revendications 8 à 10, **caractérisé en ce que** les bornes (3) de raccordement de courant du dispositif de chauffage à tube d'enveloppe sont disposées sur le côté de la structure porteuse (4) située face au dispositif de chauffage à tube d'enveloppe.

12. Installation de traitement de substrats comprenant au moins une installation de traitement de substrat ainsi qu'une installation de transport qui transporte des substrats dans la chambre, **caractérisée en ce qu'**au moins un dispositif de chauffage de surface selon l'une des revendications 1 à 9 est disposé dans le chambre.

13. Installation de traitement de substrats selon la revendication 12, **caractérisée en ce que** l'installation de transport comporte un ensemble de cylindres ou de rouleaux de transport pour substrats en forme de plaque ou des supports de substrats qui définissent un plan de transport des substrats, le dispositif de chauffage de surface étant disposé de telle sorte que le plan principal soit orienté parallèlement au plan du transport.

14. Installation de traitement de substrats selon la revendication 12, **caractérisée en ce que** des tronçons tubulaires rectilignes (1) du dispositif de chauffage à tube d'enveloppe sont disposés perpendiculairement à la direction de transport des substrats.
